# EUROPÄISCHE PATENTSCHRIFT

(11) **EP 2 605 895 B1**
(45) Veröffentlichungstag und Bekanntmachung des Hinweises auf die Patenterteilung: **25.06.2014**
(21) Anmeldenummer: 11748304.0
(22) Anmeldetag: 20.07.2011
(51) Int. Cl.: B29C 43/14, B29C 43/18, H01L 33/52, B29C 33/68

(54) **VERFAHREN ZUR HERSTELLUNG EINES SCHICHTVERBUNDS AUS EINER LUMINESZENZKONVERSIONSSCHICHT UND EINER STREUSCHICHT**
METHOD OF FABRICATING A MULTILAYER STRUCTURE HAVING A LUMINESCENCE CONVERSION LAYER AND A SCATTER LAYER
PROCÉDÉ DE FABRICATION D'UN COMPOSITE STRATIFIÉ CONSTITUÉ D'UNE COUCHE DE CONVERSION DE LUMINESCENCE ET D'UNE COUCHE DE DIFFUSION

(30) Priorität: 20.08.2010 DE 102010034923
(43) Veröffentlichungstag der Anmeldung: 26.06.2013
(73) Patentinhaber: OSRAM Opto Semiconductors GmbH, 93055 Regensburg (DE)
(72) Erfinder: PREUSS, Stephan, 93077 Bad Abbach (DE); BEMMERL, Thomas, 92421 Schwandorf (DE)
(74) Vertreter: Epping - Hermann - Fischer
(86) Internationale Anmeldenummer: PCT/EP2011/062470
(87) Internationale Veröffentlichungsnummer: WO 2012/022576

(56) Entgegenhaltungen:
- WO-A2-2011/009677
- US-A- 5 641 564
- US-A1- 2005 158 893
- US-A1- 2006 186 576
- US-A1- 2008 111 284
- DATABASE WPI Week 199147 Thomson Scientific, London, GB; AN 1991-343867 XP002665794, -& JP 3 230337 A (SUMITOMO BAKELITE CO) 14. Oktober 1991 (1991-10-14)

## Beschreibung

Die Erfindung betrifft ein Verfahren zur Herstellung eines Schichtverbunds, der eine Lumineszenzkonversionsschicht und eine Streuschicht aufweist, wobei der Schichtverbund insbesondere zur Verwendung in einem strahlungsemittierenden optoelektronischen Bauelement vorgesehen ist.

Aus der Druckschrift WO97/50132 ist ein strahlungsemittierendes optoelektronisches Bauelement bekannt, bei dem zumindest ein Teil der von einer aktiven Schicht des optoelektronischen Bauelements emittierten Strahlung mittels einer Lumineszenzkonversionsschicht zu größeren Wellenlängen hin konvertiert wird. Auf diese Weise kann z. B. mit einer strahlungsemittierenden aktiven Zone, die ultraviolettes oder blaues Licht emittiert, mischfarbiges oder weißes Licht erzeugt werden. Mittels der Lumineszenzkonversionsschicht wird dabei in der Regel ultraviolettes oder blaues Licht in Licht einer längeren Wellenlänge, insbesondere in Licht einer Komplementärfarbe wie beispielsweise gelb, umgewandelt, um auf diese Weise weißes Licht zu erzeugen.

Bei dieser Art der Weißlichterzeugung mittels Lumineszenzkonversion ist oftmals der optische Eindruck des optoelektronischen Bauelements im ausgeschalteten Zustand nicht zufriedenstellend. Dies beruht darauf, dass die Lumineszenzkonversionsschicht in einer hellen Umgebung auch im ausgeschalteten Zustand des optoelektronischen Bauelements zur Emission von gelbem Licht angeregt wird, das aber im Gegensatz zum Betriebszustand nicht mit emittiertem ultravioletten oder blauen Licht zu Weißlicht gemischt wird. Folglich weist die Oberfläche des optoelektronischen Bauelements im ausgeschalteten Zustand in den Bereichen, die mit der Lumineszenzkonversionsschicht versehen sind, die Farbe der mittels Lumineszenzkonversion erzeugten längeren Wellenlänge, beispielsweise gelb, auf, die von Betrachtern oftmals als unschön empfunden wird. Dies ist insbesondere bei vergleichsweise großflächigen Beleuchtungseinheiten, die z. B. auf organischen Leuchtdioden (OLEDs) basieren, aber auch bei LEDs oder LED-Modulen mit einem oder mehreren strahlungsemittierenden Halbleiterchips der Fall.

Um den gelben Farbeindruck der Lumineszenzkonversionsschicht im ausgeschalteten Zustand eines strahlungsemittierenden optoelektronischen Halbleiterchips zu vermindern, wird in der Druckschrift DE 10 2006 051 746 A1 vorgeschlagen, eine lichtstreuende Schicht, die beispielsweise Streupartikel enthält, über der Lumineszenzkonversionsschicht anzuordnen.

Bei strahlungsemittierenden optoelektronischen Bauelementen, die eine derartige Schichtenfolge aus einer Lumineszenzkonversionsschicht und einer Streuschicht aufweisen, ist der resultierende Farbeindruck im eingeschalteten und/oder ausgeschalteten Zustand insbesondere abhängig von den Dicken der Lumineszenzkonversionsschicht und der Streuschicht sowie der Beschaffenheit der Grenzflächen dieser Schichten. Insbesondere können Abweichungen in den Schichtdicken der Lumineszenzkonversionsschicht und/oder der Streuschicht zu einer Abweichung des Farbeindrucks des optoelektronischen Bauelements von einem gewünschten Sollwert führen.

Die Druckschrift US 2005/0158893 A1 beschreibt ein Verfahren zur Herstellung einer Deckschicht aus einem Kunststoff für lichtemittierende Bauelemente, wobei die Deckschicht in einer Formpresse hergestellt wird und Linsenelemente aufweisen kann.

In der Druckschrift WO 2011/009677 A2 wird ein Verfahren zur Herstellung eines optischen Elements für ein optoelektronisches Bauteil beschrieben, bei dem in einer Formpresse ein Grundkörper aus einer Formmasse mit einer Folie verbunden wird, die einen Diffusor oder ein Lumineszenzkonversionsmittel enthalten kann.

Eine Aufgabe der Erfindung besteht darin, ein Verfahren zur Herstellung eines Schichtverbunds mit einer Lumineszenzkonversionsschicht und einer Streuschicht anzugeben, das es ermöglicht, die Schichten des Schichtverbunds mit einer hohen Genauigkeit in Bezug auf ihre Schichtdicken und ihre Abmessungen herzustellen, wobei der Herstellungsaufwand verhältnismäßig gering ist.

Diese Aufgabe wird durch ein Verfahren zur Herstellung eines Schichtverbunds mit einer Lumineszenzkonversionsschicht und einer Streuschicht gemäß dem unabhängigen Anspruch 1 gelöst. Vorteilhafte Ausgestaltungen und Weiterbildungen der Erfindung sind Gegenstand der abhängigen Ansprüche.

Bei dem Verfahren zur Herstellung eines Schichtverbunds mit einer Lumineszenzkonversionsschicht und einer Streuschicht wird ein Formpressverfahren (compression molding) eingesetzt. Es wird eine Formpresse verwendet, die ein erstes Presswerkzeug und ein zweites Presswerkzeug aufweist. Das erste Presswerkzeug ist beispielsweise das untere Presswerkzeug und das zweite Presswerkzeug das obere Presswerkzeug der Formpresse. Beim Pressvorgang können das erste Presswerkzeug und das zweite Presswerkzeug mit hohem Druck zusammengepresst werden, um ein in der Presse befindliches Material, insbesondere ein Polymer, in eine durch die Form der Presswerkzeuge definierte Form zu pressen.

Vorzugsweise weist das erste Presswerkzeug, insbesondere das untere Presswerkzeug der Formpresse, eine Kavität auf, in die ein vorzugsweise flüssiges Polymer eingefüllt werden kann.

Bei dem Verfahren wird ein erstes Polymer, das einen Lumineszenzkonversionsstoff enthält, in die Kavität des ersten Presswerkzeugs eingefüllt. Die Dicke der mit dem Verfahren hergestellten Lumineszenzkonversionsschicht kann vorteilhaft sehr genau durch die Füllmenge des in die Kavität des ersten Presswerkzeugs eingefüllten ersten Polymers eingestellt werden.

Weiterhin wird bei dem Verfahren eine Trägerfolie zwischen das erste und das zweite Presswerkzeug eingelegt. Die Trägerfolie dient dazu, den Schichtverbund nach Durchführen des Verfahrens auf einfache Weise aus der Formpresse entnehmen zu können. Als Trägerfolie wird vorzugsweise eine besonders temperaturstabile Folie, beispielsweise aus PI (Polyimid) oder ETFE (Ethylen-Tetrafluorethylen) verwendet.

Nachfolgend wird die Formpresse geschlossen und ein erster Pressvorgang durchgeführt. Das erste Polymer wird danach in der vorzugsweise noch geschlossenen Formpresse zu einer Lumineszenzkonversionsschicht ausgehärtet.

Nachfolgend wird die Formpresse geöffnet, wobei die hergestellte Lumineszenzkonversionsschicht auf der Trägerfolie haftet. Die Trägerfolie mit der darauf haftenden Lumineszenzkonversionsschicht wird zu diesem Zeitpunkt noch nicht aus der Formpresse herausgenommen, sondern verbleibt weiterhin in der Formpresse. Insbesondere kann die Trägerfolie mit der darauf haftenden Lumineszenzkonversionsschicht an dem zweiten Presswerkzeug gehaltert sein.

Danach wird ein zweites Polymer, das Streupartikel enthält, in die Kavität des ersten Presswerkzeugs eingefüllt. Wie im Fall der Lumineszenzkonversionsschicht kann die Dicke der mit dem Verfahren hergestellten Streuschicht sehr genau über die Füllmenge des in die Kavität des ersten Presswerkzeugs eingefüllten zweiten Polymers eingestellt werden.

Die Formpresse wird nachfolgend erneut geschlossen und ein zweiter Pressvorgang durchgeführt, bei dem das zweite Polymer auf die noch in der Formpresse vorhandene Lumineszenzkonversionsschicht aufgepresst wird.

Nachfolgend wird das zweite Polymer in der vorzugsweise noch geschlossenen Formpresse zu einer auf der Lumineszenzkonversionsschicht angeordneten Streuschicht ausgehärtet. Anschließend wird die Formpresse geöffnet und die Trägerfolie mit dem Schichtverbund aus der Lumineszenzkonversionsschicht und der Streuschicht entnommen. Der Schichtverbund aus der Lumineszenzkonversionsschicht und der Streuschicht, der auf der Trägerfolie haftet, kann nachfolgend von der Trägerfolie abgenommen und insbesondere auf einen strahlungsemittierenden optoelektronischen Halbleiterchip aufgebracht werden.

Mit dem beschriebenen Verfahren zur Herstellung eines Schichtverbunds aus der Lumineszenzkonversionsschicht und der Streuschicht lässt sich vorteilhaft eine hohe Genauigkeit in Bezug auf die Ebenheit, Planparallelität, Schichtdicke und Rauheit der Lumineszenzkonversionsschicht und der Streuschicht erzielen. Beim Aufbringen des Schichtverbunds auf einen strahlungsemittierenden Halbleiterchip wird vorteilhaft eine gute Homogenität hinsichtlich Weißeindruck, Farbort und Helligkeit ezielt. Insbesondere sind diese Größen bei der Serienherstellung gut reproduzierbar.

Bei einer bevorzugten Ausgestaltung weisen das erste Polymer und das zweite Polymer das gleiche Grundmaterial auf. Unter dem Grundmaterial wird dabei das Material verstanden, in das der Lumineszenzkonversionsstoff im Fall der Lumineszenzkonversionsschicht oder die Streupartikel im Fall der Streuschicht eingebettet sind. Das Grundmaterial der Lumineszenzkonversionsschicht und der Streuschicht ist vorteilhaft also abgesehen von diesen eingebetteten Zusatzstoffen das gleiche. Dies hat einerseits den Vorteil, dass die Lumineszenzkonversionsschicht und die Streuschicht gut aufeinander haften. Weiterhin werden auf diese Weise Reflexionsverluste an der Grenzfläche zwischen der Lumineszenzkonversionsschicht und der Streuschicht vermindert.

Bei einer vorteilhaften Ausgestaltung ist das Grundmaterial der Lumineszenzkonversionsschicht und/oder der Streuschicht ein Silikon. Silikone zeichnen sich durch eine hohe Langzeitstabilität, insbesondere eine geringe Empfindlichkeit gegenüber UV-Strahlung, aus.

Bei einer bevorzugten Ausgestaltung ist die Trägerfolie auf einen Trägerrahmen aufgespannt. Mittels des Trägerrahmens kann die Trägerfolie auf einfache Weise in die Formpresse eingelegt und nach den Pressvorgängen wieder herausgenommen werden.

Vorzugsweise wird vor dem Einfüllen des ersten und/oder des zweite Polymers eine Folie in die Kavität des ersten Presswerkzeugs eingelegt. Auf diese Weise werden die Kavität und das in die Kavität eingefüllte Material vorteilhaft vor Verunreinigungen geschützt. Vorzugsweise wird eine Folie verwendet, auf der das in die Kavität eingefüllte erste und/oder zweite Polymer nur eine geringe Haftung aufweist. Auf diese Weise wird erreicht, dass die beim Pressvorgang hergestellte Lumineszenzkonversionsschicht auf der Trägerfolie, nicht aber auf der Folie in der Kavität haften bleibt.

Die in die Kavität eingelegte Folie wird vorzugsweise durch einen Unterdruck in der Kavität fixiert. Beispielsweise kann die Kavität Ansaugöffnungen aufweisen, die an eine Vakuumpumpe angeschlossen werden können. Dadurch, dass die Folie durch einen Unterdruck in der Kavität fixiert wird, passt sie sich vorteilhaft der Kontur der Kavität an.

Die Kavität in dem ersten Presswerkzeug wird vorteilhaft nach dem Schließen der Formpresse evakuiert, bevor der Pressvorgang durchgeführt wird. Auf diese Weise wird vermieden, dass in der beim Pressvorgang erzeugten Lumineszenzkonversionsschicht und/oder Streuschicht Lufteinschlüsse oder Inhomogenitäten der Dicke auftreten, die in einem optoelektronischen Bauelement zu Farbinhomogenitäten führen könnten.

Die Lumineszenzkonversionsschicht weist vorzugsweise eine Dicke zwischen einschließlich 10 µm und einschließlich 200 µm auf. Wie die Lumineszenzkonversionsschicht weist auch die beim zweiten Pressvorgang hergestellte Streuschicht vorzugsweise eine Dicke zwischen einschließlich 10 µm und einschließlich 200 µm auf. Insbesondere können die Lumineszenzkonversionsschicht und die Streuschicht gleich dick sein.

Geeignete Lumineszenzkonversionsstoffe, die in der Lumineszenzkonversionsschicht enthalten sind, sind z. B. in der Druckschrift WO98/12757 beschrieben, deren Inhalt insofern hiermit durch Rückbezug aufgenommen wird. Bei den Streupartikeln, die in der Streuschicht enthalten sind, kann es sich insbesondere um Partikel aus TiO₂ handeln. Es können aber auch andere Partikel eingesetzt werden, deren Brechungsindex sich vom Brechungsindex des Grundmaterials der Streuschicht unterscheidet, wie beispielsweise Partikel aus Al₂O₃ oder Partikel aus Glas oder Kunststoff, die beispielsweise kugelförmig oder hohlkugelförmig sind. Die Streupartikel weisen vorzugsweise einen Radius zwischen einschließlich 50 nm und einschließlich 1000 nm auf.

Der Schichtverbund aus der Lumineszenzkonversionsschicht und der Streuschicht kann nach der Herstellung vorzugsweise mittels Stanzen, Schneiden, Wasserstrahlschneiden oder mittels eines Laserstrahls auf eine gewünschte Größe zugeschnitten werden.

Der Schichtverbund aus der Lumineszenzkonversionsschicht und der Streuschicht kann insbesondere auf einen strahlungsemittierenden optoelektronischen Halbleiterchip aufgebracht werden. Insbesondere kann der Schichtverbund auf den Halbleiterchip aufgeklebt werden. Der Schichtverbund wird dabei derart auf den optoelektronischen Halbleiterchip aufgebracht, dass die Lumineszenzkonversionsschicht dem Halbleiterchip zugewandt ist, sodass die Streuschicht der Lumineszenzkonversionsschicht in der Abstrahlrichtung der von dem optoelektronischen Halbleiterchip emittierten Strahlung nachfolgt.

Die Erfindung wird im Folgenden anhand von Ausführungsbeispielen im Zusammenhang mit den Figuren 1 bis 9 näher erläutert.

Es zeigen:
- Figuren 1 bis 8: eine schematische Darstellung eines Ausführungsbeispiels des Verfahrens zur Herstellung eines Schichtverbunds aus einer Lumineszenzkonversionsschicht und einer Streuschicht anhand von Zwischenschritten und
- Figur 9: eine schematische Darstellung eines Ausführungsbeispiels eines optoelektronischen Halbleiterchips mit dem Schichtverbunds.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

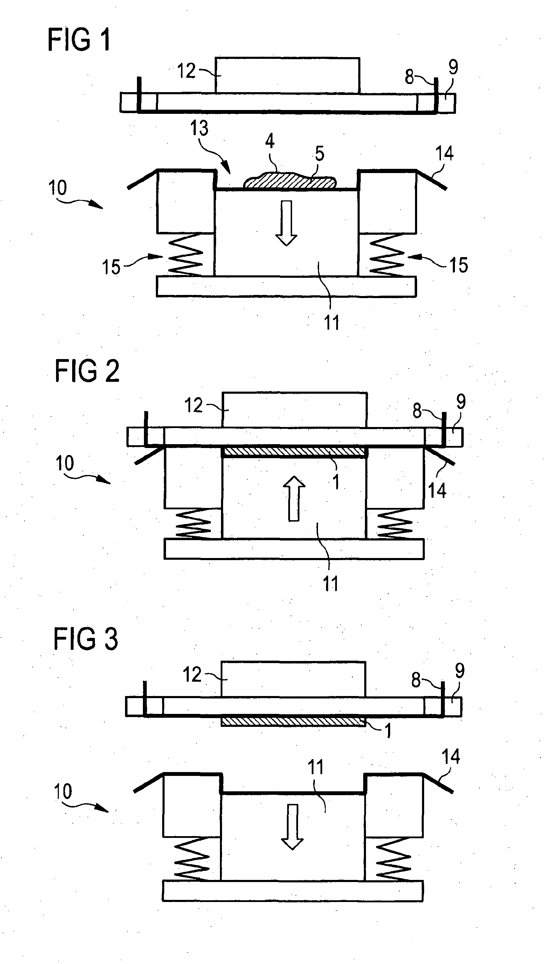

Bei dem hierin beschriebenen Verfahren wird der Schichtverbund aus einer Lumineszenzkonversionsschicht und einer Streuschicht mittels Formpressens hergestellt. In Figur 1 ist ein erster Zwischenschritt des Verfahrens dargestellt. Bei dem Verfahren wird eine Formpresse 10 verwendet, die in Figur 1 schematisch im Querschnitt dargestellt ist. Die Formpresse 10 weist ein erstes Presswerkzeug 11 und ein zweites Presswerkzeug 12 auf. Beispielsweise ist das erste Presswerkzeug 11 das untere Presswerkzeug und das zweite Presswerkzeug 12 das obere Presswerkzeug. Das erste Presswerkzeug 11 weist eine Kavität 13 auf, in die vor dem Pressvorgang ein flüssiges Polymer eingefüllt werden kann. Die Größe der Kavität 13 kann beispielsweise mittels eines Federpakets 15 an die Füllmenge angepasst werden. Vor dem Befüllen der Kavität 13 wird vorzugsweise eine Folie 14 in die Kavität 13 eingelegt, welche die Kavität 13 vor Verunreinigungen schützt und nach dem Pressvorgang das Herausnehmen des beim Pressvorgang hergestellten Formteils erleichtert. Die Folie 14 kann beispielsweise ETFE (Ethylen-Tetrafluorethylen) enthalten. Die Folie 14 wird vorteilhaft mittels eines Unterdrucks derart angesaugt, dass sie sich der Kontur der Kavität 13 anpasst. Das untere Presswerkzeug 11 kann dazu geeignete Ansaugöffnungen aufweisen (nicht dargestellt). Weiterhin wird vor dem Pressvorgang bevorzugt eine Trägerfolie 8 zwischen das erste Presswerkzeug 11 und das zweite Presswerkzeug 12 eingelegt. Bei dem Ausführungsbeispiel der Figur 1 ist die Trägerfolie 8 auf einen Trägerrahmen 9 aufgespannt, wobei der Trägerrahmen 9 am zweiten Presswerkzeug 12 fixiert ist.

In die Kavität 13 ist ein flüssiges erstes Polymer 4 eingefüllt. Das erste Polymer 4 dient zur Herstellung der Lumineszenzkonversionsschicht und weist als Basismaterial vorzugsweise ein Silikon auf. Das Basismaterial enthält einen Lumineszenzkonversionsstoff 5. Geeignete Lumineszenzkonversionsstoffe sind beispielsweise aus der Druckschrift WO97/50132 bekannt und werden daher nicht näher erläutert.

Bei dem in Figur 2 dargestellten Zwischenschritt wurde die Formpresse 10 geschlossen, um einen ersten Pressvorgang durchzuführen, bei dem das erste Presswerkzeug 11 und das zweite Presswerkzeug 12 unter hohem Druck gegeneinander gepresst werden. Vorteilhaft wird die Formpresse 10 nach dem Schließen und vor der Durchführung des Pressvorgangs evakuiert, um zu vermeiden, dass sich Lufteinschlüsse in der beim Pressvorgang hergestellten Schicht ausbilden. Das zwischen den Presswerkzeugen 11, 12 enthaltene Polymer wird auf diese Weise zu einer vorteilhaft ebenen und gleichmäßig dicken Lumineszenzkonversionsschicht 1 gepresst. Die Lumineszenzkonversionsschicht 1 weist vorzugsweise eine Dicke zwischen einschließlich 10 µm und einschließlich 200 µm auf, die über die Menge des zuvor eingefüllten ersten Polymers eingestellt werden kann. Die Lumineszenzkonversionsschicht 1 wird vorzugsweise in der noch geschlossenen Formpresse 10 derart ausgehärtet, dass sie formstabil ist.

Bei dem in Figur 3 dargestellten Zwischenschritt ist die Formpresse 10 wieder geöffnet worden. Die bei dem ersten Pressvorgang hergestellte Lumineszenzkonversionsschicht 1 haftet vorteilhaft auf der Trägerfolie 8, die mit dem Trägerrahmen 9 an dem zweiten Presswerkzeug 12 befestigt ist. Damit die Lumineszenzkonversionsschicht 1 nach dem Öffnen der Formpresse 10 an der Trägerfolie 8 und nicht an der Folie 14 in dem ersten Presswerkzeug 11 haftet, wird für die Trägerfolie 8 vorzugsweise ein Material verwendet, an dem das Polymer der Lumineszenzkonversionsschicht 1 eine stärkere Haftung aufweist als an dem Material der Folie 14. Als Material für die Trägerfolie 8 kann insbesondere ein Ethylen-Tetrafluorethylen (ETFE) oder ein Polyimid (PI) verwendet werden.

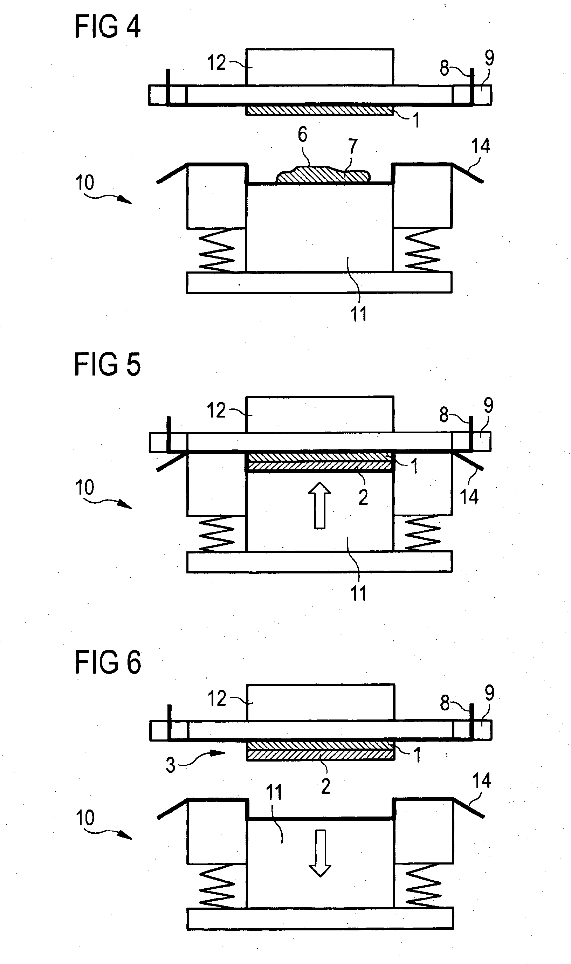

Bei dem in Figur 4 dargestellten Zwischenschritt ist ein zweites Polymer 6 in die Kavität 13 des ersten Presswerkzeugs 11 eingefüllt worden. Das zweite Polymer 6 dient zur Herstellung der Streuschicht und enthält vorzugsweise ein Silikon als Basismaterial, das mit Streupartikeln 7 versetzt ist. Die Streupartikel 7 sind beispielsweise TiO₂-Partikel. Als Streupartikel 7 können aber auch andere Materialien verwendet werden, deren Brechungsindex sich von dem Brechungsindex des Basismaterials des zweiten Polymers 6 unterscheidet.

Die zuvor hergestellte Lumineszenzkonversionsschicht 1 befindet sich noch in der Formpresse 10 und ist mittels des Trägerrahmens 9 der Trägerfolie 8 über der Kavität 13 an dem zweiten Presswerkzeug 12 befestigt.

Bei dem in Figur 5 dargestellten Zwischenschritt wird ein zweiter Pressvorgang durchgeführt, bei dem das zuvor eingefüllte zweite Polymer, das die Streupartikel enthält, zu einer Streuschicht 2 gepresst wird. Die Formpresse 10 wird vor dem Pressvorgang vorteilhaft erneut evakuiert. Die Streuschicht 2 wird bei dem Pressvorgang auf die zuvor hergestellte Lumineszenzkonversionsschicht 1 aufgepresst. Die bei dem zweiten Pressvorgang hergestellte Streuschicht 2 hat vorzugsweise eine Dicke zwischen einschließlich 10 µm und einschließlich 200 µm. Durch das Aufpressen der Streuschicht 2 auf die Lumineszenzkonversionsschicht 1 wird ein Schichtverbund hergestellt, der sich vorteilhaft durch sehr ebene Grenzflächen und eine gute Homogenität der Dicken der beiden Schichten auszeichnet. Die Streuschicht 2 wird vorteilhaft noch in der geschlossenen Formpresse 10 ausgehärtet.

Bei dem in Figur 6 dargestellten Zwischenschritt wurde die Formpresse 10 wieder geöffnet. Der Schichtverbund 3, der aus der Lumineszenzkonversiorisschicht 1 und der darauf aufgebrachten Streuschicht 2 besteht, haftet auf der Trägerfolie 8, die mittels des Trägerrahmens 9 am zweiten Presswerkzeug 12 befestigt ist. Die Lumineszenzkonversionsschicht 1 und die Streuschicht 2 haften besonders gut aufeinander, wenn sie aus dem gleichen Basismaterial hergestellt werden. Abgesehen von den eingebetteten Lumineszenzkonversionsstoffen und den Streupartikeln sind die Lumineszenzkonversionsschicht 1 und die Streuschicht 2 vorteilhaft aus dem gleichen Polymer, insbesondere einem Silikon, gebildet.

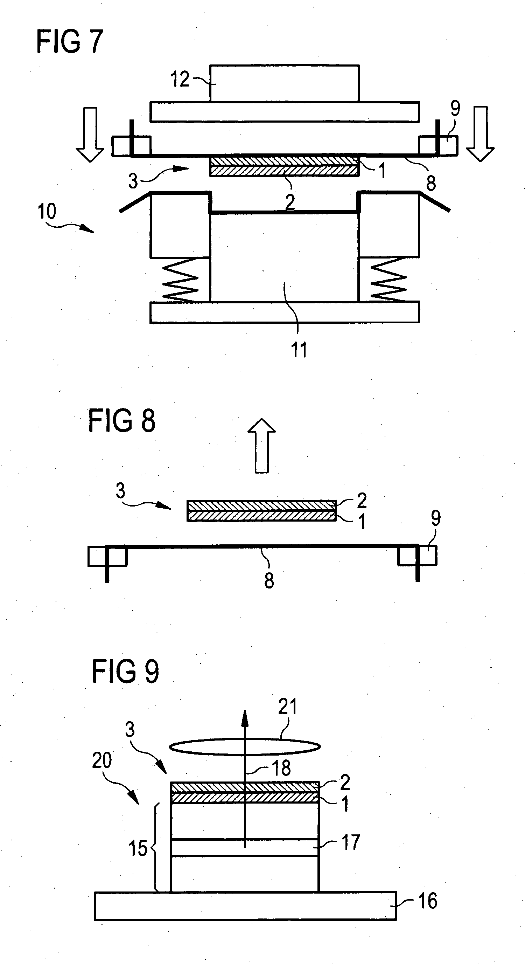

Die Trägerfolie 8 mit dem darauf haftenden Schichtverbund 3 aus der Lumineszenzkonversionsschicht 1 und der Streuschicht 2 kann nachfolgend, wie in Figur 7 dargestellt, mittels des Trägerrahmens 9 aus der Formpresse 10 herausgenommen werden.

Nachfolgend kann der Schichtverbund 3, wie in Figur 8 dargestellt, von der Trägerfolie 8 abgenommen werden. Falls erforderlich, kann der Schichtverbund 3 nun auf eine für die Anwendung gewünschte Größe zugeschnitten werden, beispielsweise durch Stanzen, Schneiden, Wasserstrahlschneiden oder Laserstrahlschneiden.

Der auf diese Weise hergestellte Schichtverbund 3 aus der Lumineszenzkonversionsschicht 1 und der Streuschicht 2 kann insbesondere auf einen optoelektronischen Halbleiterchip, insbesondere eine LED, aufgebracht werden. In Figur 9 ist ein Ausführungsbeispiel eines optoelektronischen Halbleiterchips 20 dargestellt, bei dem der Schichtverbund 3 aus der Lumineszenzkonversionsschicht 1 und der Streuschicht 2 auf die Halbleiterschichtenfolge 15 des Halbleiterchips 20 aufgebracht ist.

Die beispielsweise auf ein Trägersubstrat 16 aufgebrachte Halbleiterschichtenfolge 15 weist eine aktive Schicht 17 auf, die elektromagnetische Strahlung emittiert. Insbesondere kann die aktive Schicht 17 ultraviolette oder blaue Strahlung emittieren. Hierzu ist insbesondere eine Halbleiterschichtenfolge 15, die auf einem Nitridverbindungshalbleitermaterial basiert, geeignet.

Mittels der Lumineszenzkonversionsschicht 1 wird ein Teil der von der aktiven Schicht 17 emittierten Strahlung zu einer längeren Wellenlänge, beispielsweise gelbes Licht, konvertiert. Von dem Halbleiterchip 20 wird daher ein Mischlicht 18 emittiert, das die von der aktiven Schicht emittierte Primärstrählung und die in der Lumineszenzkonversionsschicht 1 konvertierte Strahlung umfasst. Bei dem Mischlicht 18 kann es sich insbesondere um Weißlicht handeln. Die Streuschicht 2 auf der Lumineszenzkonversionsschicht 1 hat den Vorteil, dass sie einen gelblichen Farbeindruck der Lumineszenzkonversionsschicht 1 im ausgeschalteten Zustand des Halbleiterchips 20 vermindert.

Dem Halbleiterchip 20 kann in der Abstrahlrichtung ein optisches Element wie beispielsweise eine Linse 21 nachgeordnet sein. In diesem Fall kann der unerwünschte Effekt auftreten, dass ein Teil der auf die dem Halbleiterchip 20 zugewandte Innenseite der Linse 21 auftreffenden Strahlung in Richtung des Halbleiterchips 20 zurück reflektiert wird. Diese in Richtung des Halbleiterchips 20 zurück reflektierte Strahlung wird vorteilhaft von der Streuschicht 2 in die Abstrahlrichtung zurück reflektiert.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet.

## Patentansprüche

1. Verfahren zur Herstellung eines Schichtverbunds (3), der eine Lumineszenzkonversionsschicht (1) und eine Streuschicht (2) aufweist, bei dem eine Formpresse (10) mit einem ersten Presswerkzeug (11) und einem zweiten Presswerkzeug (12) verwendet wird, wobei das erste Presswerkzeug (11) eine Kavität (13) aufweist, mit den Schritten:
- Einfüllen eines ersten Polymers (4), das einen Lumineszenzkonversionsstoff (5) enthält, in die Kavität (13) des ersten Presswerkzeugs (11),
- Einlegen einer Trägerfolie (8) zwischen das erste (11) und das zweite (12) Presswerkzeug,
- Schließen der Formpresse (10) und Durchführung eines ersten Pressvorgangs,
- Aushärten des ersten Polymers (4) zu einer Lumineszenzkonversionsschicht (1) in der Formpresse (10),
- Öffnen der Formpresse (10), wobei die auf der Trägerfolie (8) haftende Lumineszenzkonversionsschicht (1) in der Formpresse (10) verbleib,
- Einfüllen eines zweiten Polymers (6), das Streupartikel (7) enthält, in die Kavität (13) des ersten Presswerkzeugs (11),
- Schließen der Formpresse (10) und Durchführung eines zweiten Pressvorgangs,
- Aushärten des zweiten Polymers (6) zu einer auf der Lumineszenzkonversionsschicht (1) angeordneten Streuschicht (2) in der Formpresse (10),
- Öffnen der Formpresse (10) und Entnehmen der Trägerfolie (8) mit dem Schichtverbund (3) aus der Lumineszenzkonversionsschicht (1) und der Streuschicht (2).

2. Verfahren nach Anspruch 1,
wobei das erste Polymer (4) und das zweite Polymer (6) das gleiche Grundmaterial aufweisen.

3. Verfahren nach Anspruch 2,
wobei das Grundmaterial ein Silikon ist.

4. Verfahren nach einem der vorhergehenden Ansprüche,
wobei die Trägerfolie (8) auf einen Trägerrahmen (9) aufgespannt ist.

5. Verfahren nach einem der vorhergehenden Ansprüche,
wobei vor dem Einfüllen des ersten Polymers (4) und/oder dem Einfüllen des zweiten Polymers (6) eine Folie (14) in die Kavität (13) des ersten Presswerkzeugs (11) eingelegt wird.

6. Verfahren nach Anspruch 5,
wobei die Folie (14) durch einen Unterdruck in der Kavität (13) fixiert wird.

7. Verfahren nach einem der vorhergehenden Ansprüche,
wobei die Kavität (13) nach dem Schließen der Formpresse (10) und vor der Durchführung des Pressvorgangs evakuiert wird.

8. Verfahren nach einem der vorhergehenden Ansprüche,
wobei die Lumineszenzkonversionsschicht (1) eine Dicke zwischen einschließlich 10 µm und einschließlich 200 µm aufweist.

9. Verfahren nach einem der vorhergehenden Ansprüche,
wobei die Streuschicht (2) eine Dicke zwischen einschließlich 10 µm und einschließlich 200 µm aufweist.

10. Verfahren nach einem der vorhergehenden Ansprüche,
wobei in einem weiteren Verfahrensschritt der Schichtverbund (3) mittels Sägen, Stanzen, Schneiden, Wasserstrahlschneiden oder Laserstrahlscheiden zugeschnitten wird.

11. Verfahren nach einem der vorhergehenden Ansprüche,
wobei in einem weiteren Verfahrensschritt der Schichtverbund (3) aus der Lumineszenzkonversionsschicht (1) und der Streuschicht (2) auf einen strahlungsemittierenden optoelektronischen Halbleiterchip (20) aufgebracht wird.

## Claims

1. Process for producing a layer composite (3) which has a luminescence conversion layer (1) and a scattering layer (2), in which a moulding press (10) having a first pressing tool (11) and a second pressing tool (12) is used, wherein the first pressing tool (11) has a cavity (13),
comprising the steps of:
- introducing a first polymer (4), which contains a luminescence conversion substance (5), into the cavity (13) of the first pressing tool (11),
- inserting a support film (8) between the first (11) and the second (12) pressing tool,
- closing the moulding press (10) and carrying out a first pressing procedure,
- hardening the first polymer (4) to form a luminescence conversion layer (1) in the moulding press (10),
- opening the moulding press (10), wherein the luminescence conversion layer (1) adhering to the support film (8) remains in the moulding press (10),
- introducing a second polymer (6), which contains scattering particles (7), into the cavity (13) of the first pressing tool (11),
- closing the moulding press (10) and carrying out a second pressing procedure,
- hardening the second polymer (6) to form a scattering layer (2), which is disposed on the luminescence conversion layer (1), in the moulding press (10),
- opening the moulding press (10) and removing the support film (8) with the layer composite (3) consisting of the luminescence conversion layer (1) and the scattering layer (2).

2. Process according to claim 1,
wherein the first polymer (4) and the second polymer (6) have the same base material.

3. Process according to claim 2, wherein the base material is a silicone.

4. Process according to any one of the preceding claims,
wherein the support film (8) is fixed onto a support frame (9).

5. Process according to any one of the preceding claims,
wherein prior to introduction of the first polymer (4) and/or the introduction of the second polymer (6) a film (14) is inserted into the cavity (13) of the first pressing tool (11).

6. Process according to claim 5,
wherein the film (14) is fixed in the cavity (13) by means of a negative pressure.

7. Process according to any one of the preceding claims,
wherein the cavity (13) is evacuated after closure of the moulding press (10) and prior to carrying out the pressing procedure.

8. Process according to any one of the preceding claims,
wherein the luminescence conversion layer (1) has a thickness of between 10 µm and 200 µm inclusive.

9. Process according to any one of the preceding claims,
wherein the scattering layer (2) has a thickness of between 10 µm and 200 µm inclusive.

10. Process according to any one of the preceding claims,
wherein in a further process step the layer composite (3) is cut by means of sawing, punching, cutting, water jet cutting or laser beam cutting.

11. Process according to any one of the preceding claims,
wherein in a further process step the layer composite (3) consisting of the luminescence conversion layer (1) and the scattering layer (2) is applied to a radiation-emitting, optoelectronic semiconductor chip (20).

## Revendications

1. Procédé de fabrication d'un composite stratifié (3), qui présente une couche de conversion de luminescence (1) et une couche de diffusion (2), dans lequel on utilise une presse de moulage (10) avec un premier outil de pressage (11) et un deuxième outil de pressage (12), dans lequel le premier outil de pressage (11) présente une cavité (13), comportant les étapes suivantes:
- verser un premier polymère (4), qui contient une substance de conversion de luminescence (5), dans la cavité (13) du premier outil de pressage (11),
- insérer une feuille de support (8) entre le premier outil de pressage (11) et le deuxième outil de pressage (12),
- fermer la presse de moulage (10) et effectuer une première opération de pressage,
- durcir le premier polymère (4) en une couche de conversion de luminescence (1) dans la presse de moulage (10),
- ouvrir la presse de moulage (10), la couche de conversion de luminescence (11) adhérente à la feuille de support (8) restant dans la presse de moulage (10),
- verser un deuxième polymère (6), qui contient des particules de diffusion (7), dans la cavité (13) du premier outil de pressage (11),
- fermer la presse de moulage (10) et effectuer une deuxième opération de pressage,
- durcir le deuxième polymère (6) en une couche de diffusion (2) disposée sur la couche de conversion de luminescence (1) dans la presse de moulage (10),
- ouvrir la presse de moulage (10) et enlever la feuille de support (8) avec le composite stratifié (3) composé de la couche de conversion de luminescence (1) et de la couche de diffusion (2).

2. Procédé selon la revendication 1, dans lequel le premier polymère (4) et le deuxième polymère (6) présentent le même matériau de base.

3. Procédé selon la revendication 2, dans lequel le matériau de base est un silicone.

4. Procédé selon l'une quelconque des revendications précédentes, dans lequel la feuille de support (8) est tendue sur un cadre de support (9).

5. Procédé selon l'une quelconque des revendications précédentes, dans lequel, avant de verser le premier polymère (4) et/ou de verser le deuxième polymère (6), on insère une feuille (14) dans la cavité (13) du premier outil de pressage (11).

6. Procédé selon la revendication 5, dans lequel on fixe la feuille (14) par une dépression dans la cavité (13).

7. Procédé selon l'une quelconque des revendications précédentes, dans lequel on évacue la cavité (13) après la fermeture de la presse de moulage (10) et avant l'exécution de l'opération de pressage.

8. Procédé selon l'une quelconque des revendications précédentes, dans lequel la couche de conversion de luminescence (1) présente une épaisseur comprise entre 10 µm et 200 µm, ces deux valeurs comprises.

9. Procédé selon l'une quelconque des revendications précédentes, dans lequel la couche de diffusion (2) présente une épaisseur comprise entre 10 pm et 200 µm, ces deux valeurs comprises.

10. Procédé selon l'une quelconque des revendications précédentes, dans lequel, au cours d'une autre étape de procédé, on découpe le composite stratifié (3) par sciage, estampage, découpage, découpage au jet d'eau ou découpage au faisceau laser.

11. Procédé selon l'une quelconque des revendications précédentes, dans lequel, au cours d'une autre étape de procédé, on dépose le composite stratifié (3) composé de la couche de conversion de luminescence (1) et de la couche de diffusion (2) sur une puce semi-conductrice (20) optoélectronique émettant un rayonnement.
